# EUROPEAN PATENT APPLICATION

(11) **EP 1 820 624 A2**
(43) Date of publication of application: **22.08.2007**
(21) Application number: 07102676.9
(22) Date of filing: 20.02.2007
(51) Int. Cl.: B29C 65/16, H05K 5/02

(54) **Case, portable device, and method for laser welding resin parts**

(30) Priority: 21.02.2006 JP 2006043682
(71) Applicant: KABUSHIKI KAISHA TOKAI RIKA DENKI SEISAKUSHO, Niwa-gun, Aichi-ken 480-0195 (JP)
(72) Inventor: Yuura, Takashi K.K. Tokai Rika Denki Seisakusho, Niwa-gun Aichi 480-0195 (JP)
(74) Representative: Karlsson, Leif Karl Gunnar

(57) **Abstract**

A technique for preventing the extrusion of fused material from between resin parts when the resin parts are laser welded. A case (12) has a resin first case part (13) transmissive to laser light (La) and including a peripheral portion, and a resin second case part (14) that absorbs laser light (La) joined with the first case part. A light reflector (S) reflective to laser light (Lb) is formed in the peripheral portion of the first case part. A laser welding portion (P1, P2, M) is formed inward from the light reflector between the first case part and the second case part and located at a region reachable by laser light transmitted through the first case part without being reflected by the light reflector. The laser welding portion is for welding the second case part to the first case part with laser light.

## Description

The present invention relates to a case formed by laser welding two synthetic resin parts, a portable device, and a method for laser welding resin parts.

Recently, laser welding has received attention as a method for joining resin parts. Laser welding locally heats a resin part with laser light to form a welded portion that welds the resin parts to each other. Further, such laser welding minimizes the effect the welding has on components inside the resin parts. Additionally, laser welding does not generate vibrations that would produce resin dust. Due to these advantages, the inventor of the present invention has considered the application of such laser welding technology to the manufacturing of portable devices. Japanese Laid-Open Patent Publication No. 2005-235837 (refer to Fig. 7) describes an example of a portable device. A portable device is used to perform wireless communication with a vehicle so as to lock and unlock the doors of the vehicle. The portable device typically includes a case formed by a first case part and a second case part. The case accommodates a circuit board including electronic components forming a communication circuit.

There is a trend for miniaturizing portable devices to improve portability. Miniaturization of the portable device has resulted in portions of the first and second case parts that are welded together through laser welding from becoming closer to the outer surface, or ornamental surface, of the portable device. Furthermore, it is also required that such welded portions of the first and second case parts be reduced in size.

However, when manufacturing the portable device, the first and second case parts, which are molded from resin, have dimensional variations. Further, a jig must be used to hold and press the first and second case parts against each other during manufacture. If there may be a dimensional variation or slight gap between the jig and the first and second case parts, laser light directed toward the first case part during laser welding may strike the first case part at a position slightly varying from the intended position. This may cause the material fused by the laser light at the welded portions to be extruded from between the joined surfaces of the first and second case parts. Furthermore, reduction in size of the welded portions of the first and second case parts would result in the fused material extruded from between the first and second case parts being more noticeable. The outer surface of the case also functions as the ornamental surface of the portable device. Therefore, the extrusion of the fused material would lower the aesthetic appeal of the portable device.

The present invention provides a case, a portable device, and a method for laser welding resin parts that prevent the extrusion of fused material from between resin parts when laser welding the resin parts.

One aspect of the present invention is a case for accommodating an object. The case has a resin first case part transmissive to laser light and including a peripheral portion. A resin second case part that absorbs laser light is joined with the first case part. A light reflector reflective to laser light is formed in the peripheral portion of the first case part. A laser welding portion is formed inward from the light reflector between the first case part and the second case part and located at a region reachable by laser light transmitted through the first case part without being reflected by the light reflector. The laser welding portion is for welding the second case part to the first case part with laser light.

A further aspect of the present invention is portable device for performing predetermined wireless communication with a communication subject. The portable device includes a case accommodating an electronic component. The case has a resin first case part transmissive to laser light and including a peripheral portion. A resin second case part that absorbs laser light is joined with the first case part. A light reflector reflective to laser light is formed in the peripheral portion of the first case part. A laser welding portion is formed inward from the light reflector between the first case part and the second case part and located at a region reachable by laser light transmitted through the first case part without being reflected by the light reflector. The laser welding portion is for welding the second case part to the first case part with laser light.

Another aspect of the present invention is a method for laser welding resin parts to manufacture a resin product The method includes preparing a first resin part transmissive to laser light and including a peripheral portion, preparing a second resin part that absorbs laser light, forming a light reflector reflective to laser light in the peripheral portion of the first resin part, joining the first resin part and the second resin part, and laser welding the second resin part with the first resin part at a location inward from the light reflector by emitting laser light toward the first resin part, transmitting laser light through the first resin part while partially reflecting the laser light with the light reflector, and locally heating and fusing the second resin part with the laser light transmitted through the first resin part.

Other aspects and advantages of the present invention will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:
Fig. 1A is a cross-sectional view of a portable device according to a first embodiment of the present invention;
Fig. 1B is a schematic perspective view showing the portable device of Fig. 1A;
Fig. 2 is a schematic diagram showing a laser welding device;
Fig. 3 is a bottom view showing a laser light path in a state in which a cover is removed from a case of the portable device;
Fig. 4 is an enlarged cross-sectional view showing a flange of a first case part in a state joined with an open end surface of a second case part;
Fig. 5 is a perspective view showing welded portions of the first case part and the second case part;
Fig. 6A is an enlarged perspective view showing a flange in a second embodiment of the present invention;
Fig. 6B is a side view showing the flange of Fig. 6B;
Fig. 7 is an enlarged cross-sectional view showing a flange of a first case part in a state joined with an open end surface of a second case part in another embodiment of the present invention;
Figs. 8A and 8B are enlarged cross-sectional views each showing a flange of a first case part in a state joined with an open end surface of a second case part in a further embodiment of the present invention;
Figs. 9A and 9B are side views showing cases in still further embodiments of the present invention:
Figs. 10A and 10B are schematic diagrams showing laser light emissions in other embodiments of the present invention; and
Figs. 11A to 11D are cross-sectional views each showing joined portions of two resin parts in further embodiments of the present invention.

A portable device 11, which performs predetermined wireless communication with a certain communication subject, according to a first embodiment of the present invention will now be described. The portable device is used in an electronic key system together with a lock controller, which is installed in a vehicle. When a user, who is carrying the portable device 11, enters within a predetermined range set for the vehicle, the portable device 11 receives a request signal transmitted from the lock controller. In response, the portable device 11 transmits an ID signal, which contains an ID code of the portable device 11. The lock controller receives the ID signal from the portable device 11 and compares the ID code contained in the ID signal with an ID control stored in the vehicle. When the ID codes are identical, the lock controller unlocks the vehicle doors.

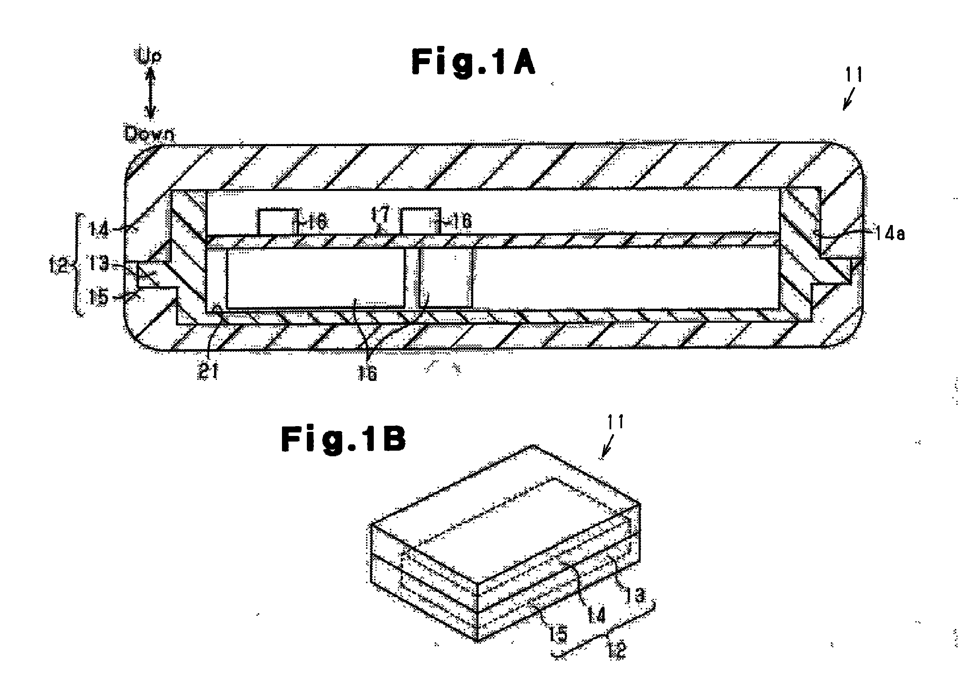

Referring to Fig. 1A, the portable device 11 includes a case 12, which includes a first case part 13, a second case part 14, and a cover 15. The first case part 13 has an upper portion, which is open, and a lower portion, as viewed in Fig. 1A. The second case part 14 has an open lower portion and is fixed to the first case part 13 so as to cover the open upper portion of the first case part 13. The cover 15 covers the lower portion of the first case part 13. When assembled together, the first case part 13, the second case part 14, and the cover 15 form a box as shown in Fig. 1B.

The first case part 13, which is integrally injection molded from a synthetic resin, is box-shaped. A board accommodation portion 21 is defined in the first case part 13. Electronic components 16, such as electronic elements forming a microcomputer and a communication circuit (none shown), are arranged on a circuit board 17 in the board accommodation portion 21. A rectangular flange 30 extends along the peripheral surface of the first case part 13 at the middle of the first case part 13 in the heightwise direction.

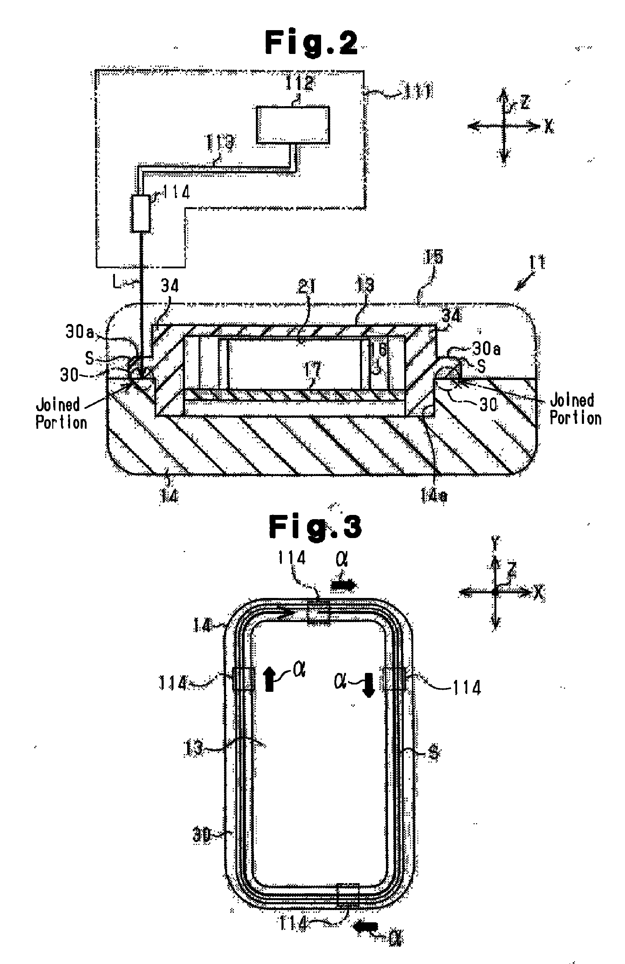

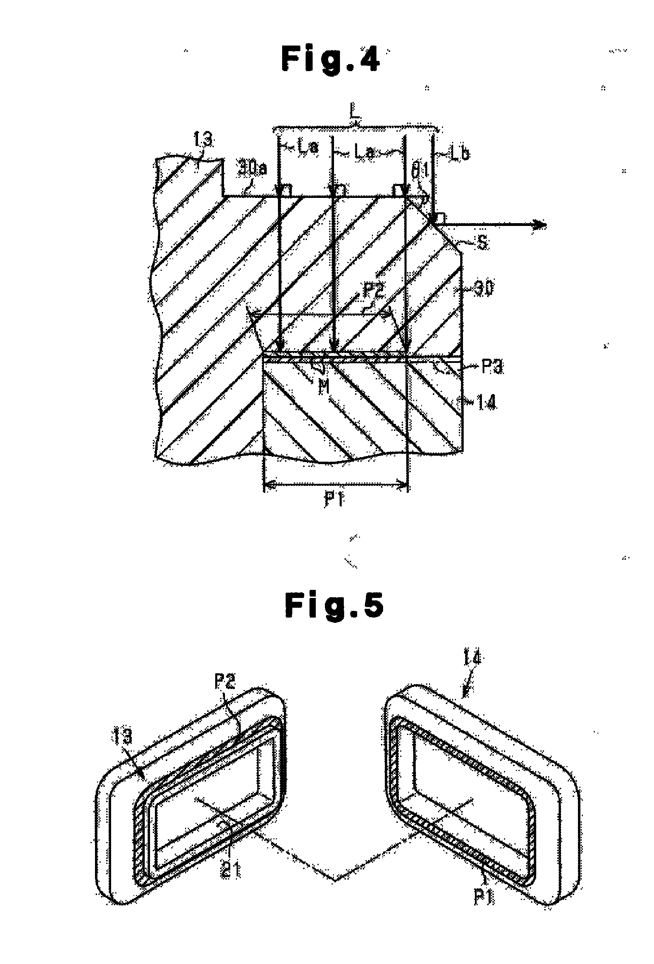

An inclined surface S continuously extends along the entire lower outer edge of the flange 30, that is the peripheral portion of the first case part 13, as shown in Fig. 3. Figs. 2 and 4 show the case 12 turned upside-down from the state of Fig. 1. The inclined surface S has a predetermined width and functions as a light reflector that reflects incident light. Referring to Fig. 4, the inclined surface S extends toward the peripheral surface of the flange 30 at a predetermined angle θ1 relative to the surface of the flange 30 that is farther from the second case part 14. The angle θ1 is set so that when predetermined light (laser light L) is directed toward the surface of the flange 30 at a right angle, the angle of incidence of the light striking the inclined surface S is greater than the critical angle. In this embodiment, the angle θ1 is set at 45 degrees. Accordingly, in the light directed toward the flange 30 at a right angle, the incident light striking the inclined surface S is reflected outward in entirety due to the difference in the refractive index of the incident light and the refractive index of air.

Referring to Fig. 1A, the second case part 14, which is integrally injection molded from a synthetic resin, is box-shaped. The opening of the second case part 14 defines a fitting portion 14a extending downward to receive the first case part 13. The portion of the first case part 13 above the upper surface of the flange 30 can be fitted into the fitting portion 14a in a state accommodating the circuit board 17. The first case part 13 and second case part 14 are fixed to each other with the upper surface of the flange 30 in engagement with the lower surface of the second case part 14, or the open end surface extending around the open end of the fitting portion 14a, as viewed in Fig. 1A. The cover 15, which is integrally injection molded from a synthetic resin, is box-shaped and has an open upper portion. Further, the cover 15 is attached to the first case part 13 in a detachable manner.

The process for joining the first case part 13 with the second case part 14 through laser welding will now be discussed. In this embodiment, a laser welding device 111 is used to thermally weld the first case part 13 and second case part 14 with each other.

The laser welding device 111 will first be briefly described. Referring to Fig. 2, the laser welding device 111 generates laser light with a laser light generator 112. The laser light travels through an optical fiber 113 and a converging lens 114. Then, the laser light is directed toward welded portions of two resin parts that are joined with each other. The laser light source used for such laser welding may be an yttrium aluminum garnet (YAG) laser, a YVO₄ laser, a glass laser, a ruby laser, a helium-neon gas laser, an argon laser, a fiber laser, or a semiconductor laser. Further, the laser light generator 112 is fixed to a housing (not shown) of the laser welding device 111. The converging lens 114 is driven by a drive device (not shown) and is movable in an XYZ coordinate system in the directions of X, Y, and Z axes. Two parts (in this embodiment, the first case part 13 and the second case part 14) are joined with each other and supported by a parts holder. In this state, the drive device is driven to move the converging lens 114 relative to the parts to direct the laser light L toward the joining portions of the parts. This enables the two parts to fuse with each other at predetermined joining portions. Instead of the converging lens 114 being moved, the parts holder may be moved.

The material of the first case part 13 and second case part 14 that are fused with each other through laser welding will now be described. The synthetic resin used to form the first case part 13 and second case part 14 may be a non-crystalline resin, such as polystyrene, polyethylene, and polycarbonate, or a crystalline resin, such as polypropylene, polybutylene terephthalate, polyethylene terephthalate, polyamide, and polyacetal. In this embodiment, polycarbonate is used.

The first case part 13 transmits laser light L, or has a transmittance relative to laser light L. The second case part 14 absorbs the laser light L, or has an absorbance relative to laser light L. The transmittance and absorbance of the first case part 13 and second case part 14 are dependent on the amount and dispersion of an additive (colorant), such as dye and pigment, in the materials forming the first case part 13 and second case part 14.

In this embodiment, pigment of a predetermined color (e.g., carbon black) is added as a laser light absorption colorant to the synthetic resin forming the second case part 14. The amount and dispersion of the absorption colorant for the synthetic resin is determined so that the second case part 14 has the required laser light absorbance for generating the necessary heat. The laser light absorption colorant may be a pigment colorant or a dye colorant. Such pigment colorant and dye colorant may be combined to generate the necessary heat. This would enable the welding conditions to be flexible. Carbon black, which is described above, is generally used as the pigment colorant.

In the synthetic resin forming the first case part 13, a dye having the same color as the pigment used for the second case part 14 is added as a coloring substance. The first case part 13 has the same color as the second case part 14 to improve the aesthetic appeal of the case 12. The type, amount, and dispersion of the dye for the synthetic resin of the first case part 13 are determined so that the first case part 13 has the required laser light transmittance. Dye has a high light absorption property although this is affected by the synthetic resin to which the dye is added. Thus, in this embodiment, pigment is added to the synthetic resin of the second case part 14, and dye is added to the synthetic resin of the first case part 13. However, a dye does not necessarily have to be added to the synthetic resin material of the first case part 13. Additionally, to increase the freedom in design, the dye added to the synthetic resin of the first case part 13 does not necessarily have to have the same color as the second case part 14. It is only necessary that the first case part 13 have the necessary laser light transmittance.

The fusing of the first case part 13 and second case part 14 with the laser welding device 111 will now be described in detail. In a state in which the circuit board 17 is facing toward the second case part 14, the first case part 13 is fitted into the fitting portion 14a of the second case part 14. The upper side of the flange 30 of the first case part 13 is engaged with the open end surface of the second case part 14, as viewed in Fig. 1A. In this state, the first case part 13 and second case part 14 are fixed to and supported by the parts holder of the laser welding device 111.

Then, laser light L is emitted and directed via the converging lens 114 toward the flange 30 from the first case part 13. More specifically, as shown by arrow α in Fig. 3, the laser light L is directed toward the flange 30 while continuously moving the converging lens 114 along the flange 30 of the first case part 13.

As shown in Fig. 4, in the laser light L directed toward the flange 30 at the side opposite the second case part 14, the incident laser light La striking a transmissive surface 30a, which is orthogonal to the laser light La, propagates through the flange 30 and reaches the open end surface of the second case part 14. The transmissive surface 30a is located adjacent to and inward from the light reflector, or the inclined surface S located at the peripheral portion of the first case part 13. In detail, the laser light La propagated through the flange 30 passes through a projection region P2, which is defined on the surface of the flange 30 joined with the second case part 14 in correspondence with the transmissive surface 30a, and reaches a projection region P1, which is defined on the open end surface of the second case part 14 in correspondence with the transmissive surface 30a. The projection region P1 of the second case part 14 absorbs the energy of the laser light La and generates heat. The heat fuses the joined portions (joined surfaces) of the projection region P1 and projection region P2 to form a fused portion M. The fused portion M is then cooled and solidified. This joins the entire projection region P1 in the open end surface of the second case part 14 with the projection region P2 in the flange 30, which are indicated by the hatching lines in Fig. 5. The flange 30 of the first case part 13 and the open end surface of the second case part 14 may be partially welded to each other at a number of locations. In this embodiment, the flange 30 serves as the joined portion of the first case part 13 and the open end surface serves as the joined portion of the second case part 14.

Referring to Fig. 4, in the laser light L emitted toward the flange 30 at the side opposite the second case part 14, the incident laser light Lb striking the inclined surface S is not transmitted through the flange 30 and reflected outward "in entirety due to the difference between the refractive indexes of the flange 30 and air. Thus, the laser light Lb is not transmitted through the flange 30. A non-projection region P3 is defined in the open end surface of the second case part 14, as indicated by the double-dashed line in Fig. 4. The non-projection region P3 in the open end surface of the second case part 14 does not receive the laser light Lb and is thus neither heated nor fused. This prevents the synthetic resin fused by the laser light L from being extruded from between the joined surfaces of the flange 30 and the second case part 14.

By applying pressure to the joined portions when or after the joined portions are fused by the laser light L, welding of the first case part 13 and second case part 14 is ensured. For example, a pressing means such as a roller may be used to press the first case part 13 against the second case part 14. The pressing means is moved in a manner following the converging lens 114 and continues to apply pressure until the joined portions of the first case part 13 and second case part 14 are cooled. Alternatively, a material such as glass that transmits laser light may be used to apply pressure during the emission of the laser light L. Furthermore, pressure may be applied to the vicinity of the portion toward which the laser light L is directed. This prevents voids (bubbles) from being produced in the welded portions of the first case part 13 and second case part 14.

The first embodiment has the advantages described below.
(1) The peripheral portion of the first case part 13 toward which the laser light L is directed includes the inclined surface S, which reflects the laser light L in a predetermined direction.
   With this structure, in the laser light L emitted from outside the first case part 13, the incident laser light Lb striking the inclined surface S changes directions due to the difference in the refractive indexes between the first case part 13 and air. Thus, the laser light Lb does not reach the surface of the second case part 14 joined with the first case part 13, that is, the portion of the second case part 14 corresponding to the inclined surface S (i.e., the non-projection region P3). As a result, the surface of the second case part 14 joined with the first case part 13 at the portion corresponding to the inclined surface S is neither heated nor fused. Accordingly, when fused by the laser light L, synthetic resin is not extruded from between the joined surfaces (joined portions) of the first case part 13 and second case part 14.
(2) The laser light L changes directions just by simply forming the inclined surface S on the flange 30 of the first case part 13.
(3) The size and thickness of the portable device 11 must be reduced to improve portability. As a result, the portions that are fused between the first case part 13 and second case part 14 forming the case of the portable device 11 must be located near the ornamental surface, or outer surface, of the portable device 11. In addition, the fused portions of the first case part 13 and second case part 14 must also be miniaturized. Under such circumstances, the case 12 of the portable device 11 is meritorious in that the fused resin of the joined surfaces is not extruded from between the first case part 13 and second case part 14.
   The outer surfaces of the first case part 13 and second case part 14 also serve as the ornamental surface of the portable device 11. Thus, when the fused resin is extruded from between the joined portions of the first case part 13 and second case part 14, the extruded resin must be removed to ensure the aesthetic appeal of the portable device. This would lower the manufacturing efficiency of the portable device 11. Comparatively, this embodiment does not require such a removal process. This improves the manufacturing efficiency of the portable device 11.
(4) The inclined surface S is integrally injection molded with the first case part 13. Compared to when forming the inclined surface S after molding the first case part 13, the manufacturing efficiency of the first case part 13 is improved. Although the inclined surface is integrally molded: with the first case part 13 in the first embodiment, the inclined surface S may be formed, for example, by machining or shot peening the first case part 13.
(5) The width of the inclined surface S may be changed to adjust the width of the welded portion. More specifically, the width of the welded portion may be decreased by increasing the width of the inclined surface S, and the width of the welded portion may be increased by decreasing the width of the inclined surface S. Accordingly, there would be no need to change the emission range of the laser light L.
(6) The formation of the welded portion may be controlled in accordance with the presence of the inclined surface S. Accordingly, the inclined surface S may be formed at locations at which extrusion of the fused resin must be avoided. This enables selective prevention of fused resin extrusion.
(7) There is no extrusion of fused resin from between the first case part 13 and second case part 14. Thus, when attaching the cover 15 to the first case part 13, the cover 15 is not interfered with by fused resin. This enables smooth attachment of the cover 15. If there were an extrusion of fused resin, the extrusion of the fused resin would interfere with the cover 15 and render the attachment of the cover 15 to the first case part 13 difficult. However, such a circumstance does not occur in this embodiment. This ensures the product reliability of the portable device 11.

A second embodiment of the present invention will now be discussed. This embodiment differs from the first embodiment in the structure of the light reflector that reflects laser light directed toward a flange of a first case part. To avoid redundancy, like or same reference numerals are given to those components that are the same as the corresponding components of the first embodiment. Such components will not be described in detail.

Referring to Fig. 6A. on the surface opposite the second case part 14, the flange 30 includes a peripheral portion having a plurality of triangular, or V-shaped, recesses 121, with each recess 121 having a predetermined width. The recesses 121 are arranged continuously throughout the entire peripheral portion of the flange 30. Accordingly, this surface of the flange 30, which is turned upside-down and used as the upper surface during laser welding, is zigzagged and saw-toothed.

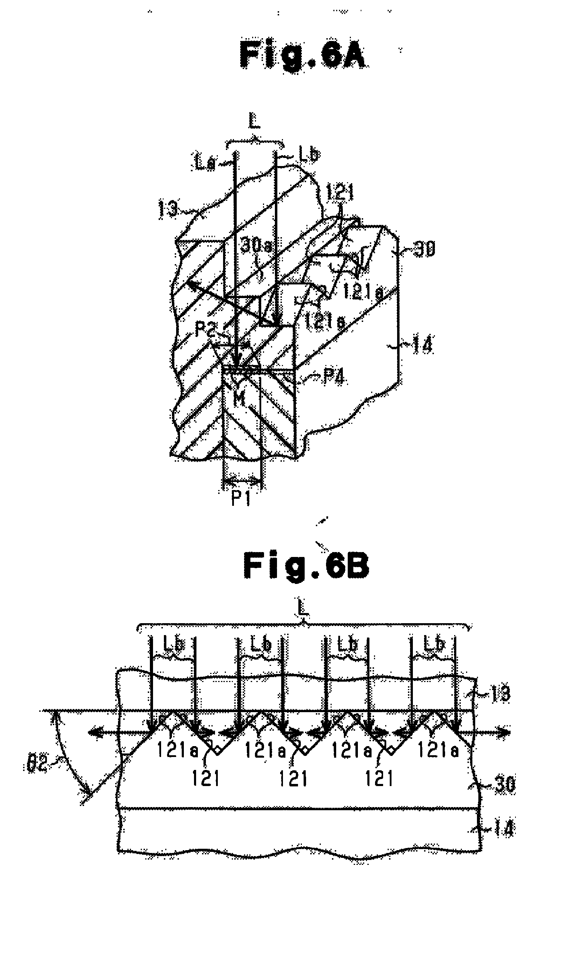

Referring to Fig. 6B, each recess 121 is formed by two inclined surfaces 121a, which are orthogonal to each other. Further, each inclined surface 121a extends at a predetermined angle θ2 relative to a plane orthogonal to the laser light L emitted toward the flange 30. The angle θ1 is set so that when laser light L is emitted toward the flange 30 at a right angle, the angle of incidence of the laser light L striking the inclined surfaces 121a is greater than the critical angle. In this embodiment, the angle θ2 is set at 45 degrees. Accordingly, in the laser light L emitted toward the lower surface of the flange 30 at a right angle, the incident light Lb striking the inclined surfaces 121a is reflected in entirety due to the difference in the refractive index of the inclined surfaces 121a and the refractive index of air.

Accordingly, in the laser light L emitted from outside the first case part 13, the incident laser light Lb striking the inclined surfaces 121a changes directions due to the difference in the refractive indexes between the first case part 13 and air. Thus, the laser light Lb does not reach the open end surface of the second case part 14, that is, the portion of the second case part 14 corresponding to the inclined surfaces 121a (i.e., non-projection region P4). As a result, the surface of the second case part 14 joined with the first case part 13 at the portion corresponding to the inclined surfaces 121a is neither heated nor fused. Accordingly, when fused by the laser light L, the synthetic resin is not extruded from between the joined surfaces (joined portions) of the first case part 13 and second case part 14.

Referring to Fig. 6A, in the laser light L directed toward the side of the flange 30 opposite the second case part 14, the incident laser light La striking the transmissive surface 30a propagates through the flange 30 and reaches the open end surface of the second case part 14. The projection region P1 of the second case part 14 that is defined in correspondence with the transmissive surface 30a absorbs the energy of the laser light La and generates heat. The heat fuses the joined portions (joined surfaces) of the projection region P1 on the second case part 14 and the projection region P2 defined on the first case part 13 in correspondence with the transmissive surface 30a. This forms a fused portion M. The fused portion M is then cooled and solidified. This joins the entire projection region P1 of the second case part 14 with the projection region P2 of the flange 30.

It should be apparent to those skilled in the art that the present invention may be embodied in many other specific forms without departing from the spirit or scope of the invention. Particularly, it should be understood that the present invention may be embodied in the following forms.

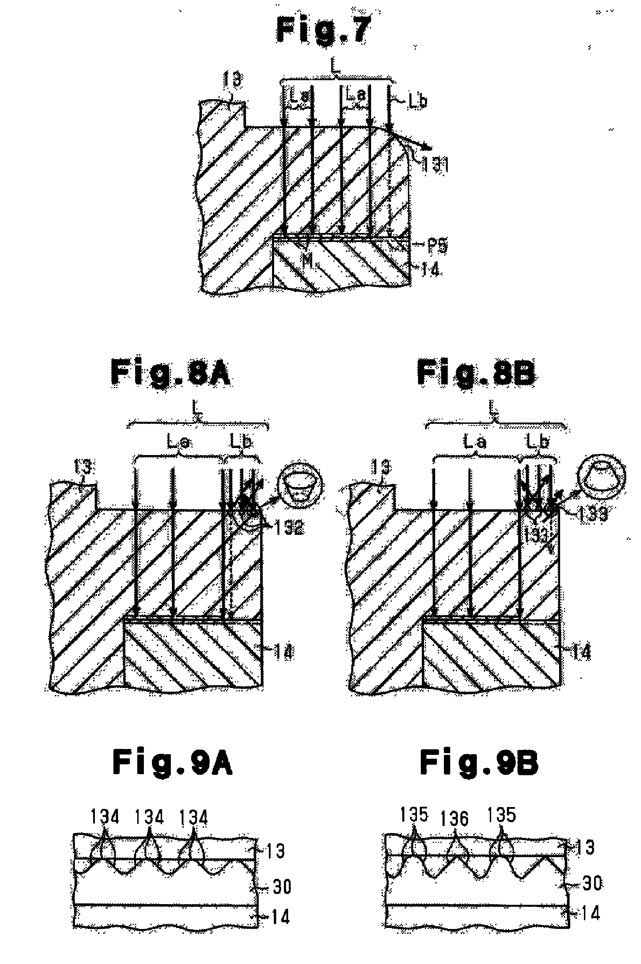

On the side of the peripheral portion of the flange 30 from which the laser light L enters, the inclined surface S is formed in the first embodiment and the recesses 121 are formed in the second embodiment. Instead, as shown in Fig. 7, a curved surface 131 having a predetermined radius of curvature may be formed in the peripheral portion of the flange 30 at the side from which the laser light L enters. In this case, the "incident laser light L striking the curved surface 131 may partially reach the open end surface of the second case part 14 as shown by the dotted arrow in Fig. 7. In such a case, however, the amount of laser light reaching the open end surface of the second case part 14 is extremely small compared to when the curved surface 131 is not formed on the flange 30. Thus, subtle heat is generated at a non-projection region P5, which is defined in correspondence with the curved surface 131, in the open end surface of the second case part 14. Further, the fused amount of synthetic resin at the non-projection region P5 is subtle. Thus, fused synthetic resin is not extruded from between the first case part 13 and second case part 14.

Further, as shown in Fig. 8A, a rough surface (irregular reflection surface) including a plurality of fine recesses 132 may be formed in the peripheral portion of the flange 30 at the side from which the laser light L enters. Also, as shown in Fig. 8B, a rough surface (irregular reflection surface) including a plurality of fine projections 133 may be formed in the peripheral portion of the flange 30 at the side from which the laser light L enters. The laser light L entering these rough surfaces is reflected and diffused in various directions. This reduces the amount of the laser light L that reaches the open end surface of the second case part 14. Thus, the amount of heat generated at the open end surface of the second case part 14 is reduced, and the fused amount of synthetic resin at this region is decreased.

As shown in Fig. 9A, an undulated light reflector including a plurality of continuous curved surfaces 134 may be formed in the entire peripheral portion of the flange 30 at the side from which the laser light L enters. Alternatively, as shown in Fig. 9B, an undulated light reflector including a combination of curved surfaces 135 and inclined surfaces 136 may be formed in the flange 30 at the side from which the laser light L enters.

The present invention is embodied in the case 12 of the portable device 11 in the first and second embodiments. However, the present invention may be embodied in a case for any kind of electronic device that incorporates electronic components and circuit boards. For example, the present invention may be embodied in a portable terminal such as a cellular phone. Furthermore, the present invention does not necessarily have to be embodied in a case that accommodates a component. The present invention may be applied to any product formed by fusing two resin molded parts.

In the first and second embodiments, the inclined surface S and the recesses 121 are integrally molded with the first case part 13. However, the first case part 13 may first be molded without the inclined surface S and the recesses 121. In such a case, the inclined surface S or the recesses 121 may be formed by machining or shot peening the flange 30 of the first case part 13. This would have the same advantages as the first and second embodiments.

As shown by the arrows α in Fig. 3, in the first and second embodiments, the laser light L is directed toward the flange 30 while continuously moving the converging lens 114 along the flange 30. However, two galvanometer mirrors (not shown) may be used to continuously move the laser light L through the converging lens 114 along the flange 30 of the first case part 13.

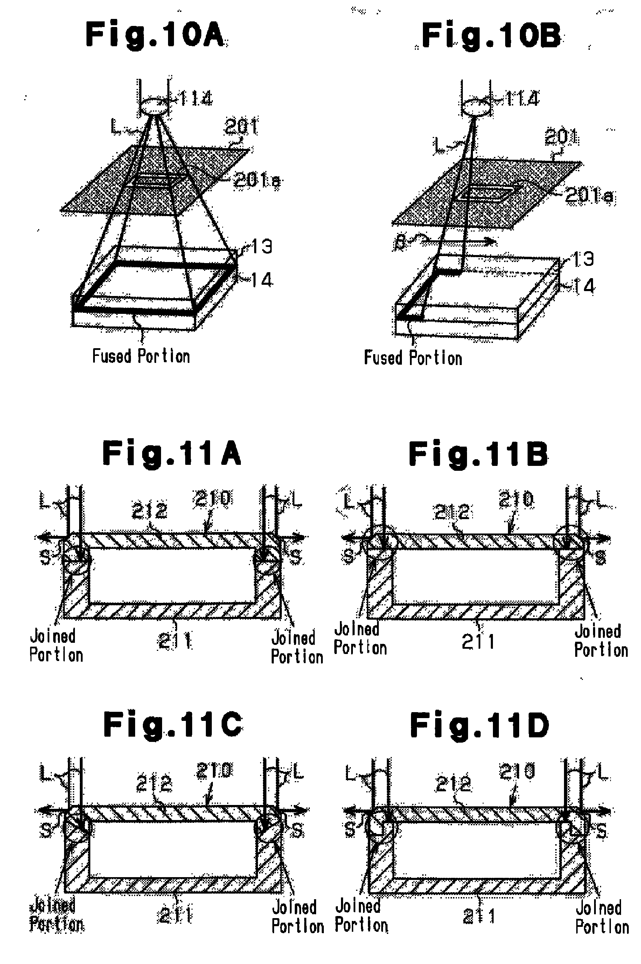

Further, instead of directing the laser light L toward the flange 30 while continuously moving the converging lens 114 along the flange 30 like in the first and second embodiments, a sheet-shaped mask 201 may be used as shown in Fig. 10A. The mask 201 is formed from a material that does not transmit the laser light L and includes a light transmission slit 201a shaped in correspondence with the welded portion. Here, the light transmission slit 201a has the shape of a square frame in correspondence with the welded portions of the first case part 13 and the second case part 14. The laser light L from the converging lens 114 is directed toward the first case part 13 through the mask 201.

In this case, as shown in Fig. 10A, the laser light L emitted from the laser welding device 111 is set so that the light transmission slit 201a is entirely included in the emission area of the laser light L. The laser light L that passes through the light transmission slit 201a of the mask 201 is directed entirely toward the welded portions of the first case part 13 and second case part 14 (mask process). The employment of such a process improves the efficiency for fusing the first case part 13 and second case part 14. The emission area of the laser light L is adjusted by using a lens (not shown) to change the focal point of the laser light or by arranging a plurality of laser lights L (or laser light sources) along a plane.

As shown in Fig. 10B, during the emission of laser light L, which is linear, the converging lens 114 may be moved, for example, in the direction indicated by arrow β (scan process). The linear laser light L may be formed by using a cylindrical lens (not shown). This would also improve the efficiency for fusing the first case part 13 with the second case part 14 in comparison with when the laser light L is directed toward the flange 30 while continuously moving the converging lens 114 along the flange 30 of the first case part 13. In Figs. 10A and 10B, the portions shown in black indicate the portions toward which the laser light L is directed.

In the first and second embodiments, the second case part 14 is thermally welded with the flange 30 of the first case part 13 in the case 12 of the portable device 11. However, the laser welding process of the first and second embodiments may be applied to join two resin molded products that do not include a flange. In this case, in the same manner as in the first and second embodiments, the inclined surface S is formed entirely or partially in the peripheral portion of one of the resin molded products toward which the laser light L is directed. The joined portions (joined surfaces) of the two resin molded products may be changed in any manner.

More specifically, as shown in Figs. 11A and 11B, a case 210 may be formed by a box-shaped case part 211 having an open upper portion and a box-shaped or relatively flat cover 212 having an open lower portion. The joined portions of the case part 211 and the cover 212 are flat. Further, as shown in Fig. 11C, the joined portions of the case part 211 and the cover 212 may be formed by inclined surfaces. Also, as shown in Fig. 11D, the joined portions of the case part 211 and the cover 212 may include steps.

In the first and second embodiments, the flange 30 of the first case part 13 is thermally welded to the second case part 14. However, the laser welding methods of the first and second embodiments may be used to manufacture cases for other types of devices such as a cellular phone. Further, the laser welding methods of the first and second embodiments may be used to join two resin parts to manufacture products other than cases.

## Claims

1. A case (12) for accommodating an object, the case having a resin first case part (13) transmissive to laser light (L, La) and including a peripheral portion, and a resin second case part (14) that absorbs laser light (L, La) joined with the first case part, the case being
**characterized by:**
a light reflector (S; 121, 121a; 131; 132, 133; 134; 135; 136) reflective to laser light (L, Lb) formed in the peripheral portion of the first case part; and
a laser welding portion (P1, P2, M) formed inward from the light reflector between the first case part and the second case part and located at a region reachable by laser light transmitted through the first case part without being reflected by the light reflector, wherein the laser welding portion is for welding the second case part to the first case part with laser light.

2. The case according to claim 1, **characterized in that** the first case part includes a light transmissive surface (30a) transmissive to laser light and located adjacent to and inward from the light reflector.

3. The case according to claim 2, **characterized in that** the light reflector includes an inclined surface (S; 121a; 136) inclined relative to the light transmissive surface.

4. The case according to any one of claims 1 to 3, **characterized in that** the light reflector includes a curved surface (134; 135).

5. The case according to any one of claims 1 to 4, **characterized in that** the light reflector includes a recess (121; 132).

6. The case according to any one of claims 1 to 5, **characterized in that** the light reflector includes a projection (133).

7. A portable device (11) for performing predetermined wireless communication with a communication subject, the portable device including a case (12) accommodating an electronic component, the case having a resin first case part (13) transmissive to laser light (L, La) and including a peripheral portion, and a resin second case part (14) that absorbs laser light (L, La) joined with the first case part, the portable device **being characterized by:**
a light reflector (S; 121, 121a; 131; 132, 133; 134; 135; 136) reflective to laser light (L, Lb) formed in the peripheral portion of the first case part; and
a laser welding portion (P1, P2, M) formed inward from the light reflector between the first case part and the second case part and located at a region reachable by laser light (L, La) transmitted through the first case part without being reflected by the light reflector, wherein the laser welding portion is for welding the second case part to the first case part with laser light.

8. The portable device according to claim 7, **characterized in that** the first case part includes a light transmissive surface (30a) transmissive to laser light and located adjacent to and inward from the light reflector.

9. The portable device according to claim 7 or 8, **characterized in that** the light reflector includes at least one of an inclined surface (S; 121a; 136), a curved surface (134; 135), a recess (121; 132), and a projection (133).

10. A method for laser welding resin parts to manufacture a resin product, the method being **characterized by**:
preparing a first resin part (13) transmissive to laser light (L, La) and including a peripheral portion;
preparing a second resin part (14) that absorbs laser light (L, La);
forming a light reflector (S; 121, 121a; 131; 132, 133; 134; 135; 136) reflective to laser light in the peripheral portion of the first resin part;
joining the first resin part and the second resin part; and
laser welding the second resin part with the first resin part at a location inward from the light reflector by emitting laser light toward the first resin part, transmitting laser light through the first resin part while partially reflecting the laser light with the light reflector, and locally heating and fusing the second resin part with the laser light transmitted through the first resin part.

11. The method according to claim 10, **characterized in that** said forming a light reflector includes integrally molding the light reflector with the first resin part.

12. The method according to claim 10 or 11, **characterized in that** said preparing a first resin part includes forming a light transmissive surface (30a) transmissive to laser light at a location adjacent to and inward from the light reflector.

13. The method according to claim 12, **characterized in that** said forming a light reflector includes forming an inclined surface (S; 121a; 136) inclined relative to the light transmissive surface.

14. The method according to any one of claims 10 to 13, **characterized in that** said forming a light reflector includes forming a curved surface (134; 135).

15. The method according to any one of claims 10 to 14, **characterized in that** said forming a light reflector includes forming a recess (121; 132).

16. The method according to any one of claims 10 to 15, **characterized in that** said forming a light reflector includes forming a projection (133).
